(19) **Europäisches Patentamt / European Patent Office / Office européen des brevets**

(11) **EP 2 637 175 B1**

(12) **EUROPEAN PATENT SPECIFICATION**

(45) Date of publication and mention
of the grant of the patent:
**24.01.2018 Bulletin 2018/04**

(51) Int Cl.:
*H01B 1/22* (2006.01)  *H01B 1/00* (2006.01)
*H01B 13/00* (2006.01)  *H05K 1/09* (2006.01)
*H05K 3/12* (2006.01)  *C08K 5/09* (2006.01)
*C08K 5/092* (2006.01)

(21) Application number: **11837934.6**

(22) Date of filing: **28.10.2011**

(86) International application number:
**PCT/JP2011/074890**

(87) International publication number:
**WO 2012/060284 (10.05.2012 Gazette 2012/19)**

(54) **LOW-TEMPERATURE SINTERING CONDUCTIVE PASTE, CONDUCTIVE FILM USING SAME, AND METHOD FOR FORMING CONDUCTIVE FILM**

LEITFÄHIGE PASTE FÜR SINTERUNGSVORGÄNGE BEI NIEDRIGER TEMPERATUR, LEITFÄHIGER FILM DAMIT UND VERFAHREN ZUR HERSTELLUNG DES LEITFÄHIGEN FILMS

PÂTE CONDUCTRICE POUR FRITTAGE À BASSE TEMPÉRATURE, FILM CONDUCTEUR METTANT EN ŒUVRE LADITE PÂTE ET PROCÉDÉ DE FORMATION DE FILM CONDUCTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.11.2010 PCT/JP2010/069453**

(43) Date of publication of application:
**11.09.2013 Bulletin 2013/37**

(73) Proprietor: **DOWA Electronics Materials Co., Ltd. Chiyoda-ku
Tokyo 101-0021 (JP)**

(72) Inventors:
• **HINOTSU, Takashi
Tokyo 101-0021 (JP)**

• **HIYAMA, Yuto
Tokyo 101-0021 (JP)**
• **UEYAMA, Toshihiko
Tokyo 101-0021 (JP)**

(74) Representative: **Gill Jennings & Every LLP
The Broadgate Tower
20 Primrose Street
London EC2A 2ES (GB)**

(56) References cited:
EP-A1- 2 581 156     JP-A- 5 094 716
JP-A- 10 162 647     JP-A- 2004 265 826
JP-A- 2007 095 509    JP-A- 2008 166 086
JP-A- 2009 298 963    JP-A- 2010 132 736
JP-A- 2010 153 184

EP 2 637 175 B1

**Description**

Field

The present invention relates to a conductive paste capable of forming a conductive circuit having an excellent conductivity even by a low-temperature treatment, a conductive film produced using the same, and a method for forming the conductive film.

Background

A conductive paste composed of metal particles, a resin, and a solvent is used for electronic devices, and particularly for a fine wiring made of metal. Recently, electronic devices are markedly reduced in size, and therefore a finer wiring is required.

Use of not only a ceramic substrate conventionally used but also a substrate made of a polymer is investigated. However, such a polymer material generally has a low heat resistance. In formation of a wiring using a conventional paste, the wiring may be deformed by a heat treatment (for example, firing at 250°C for 1 hour in the air) necessary to achieve conductivity. For application to such a substrate, a conductive paste capable of forming a conductive film even by firing at low temperatures is required.

Particularly in recent years, as the conductive paste capable of forming a conductive film even by firing at low temperatures, a paste using nano-scale metal particles (average primary particle diameter: 200 nm or less, hereinafter referred to as "metal nanoparticles") having physical properties different from micron-scale particles is investigated. The metal nanoparticles can be adopted to provide a paste particularly suitable for a fine wiring.

However, the metal nanoparticles have a very high activity and therefore are easily aggregated. For this reason, in most particles, a protective layer of an organic substance is formed on the surface of each particle to secure the independence of the particle. Although such a protective layer effectively contributes to storage of particles, it may act as an inhibiting factor when a metallic property is expressed. Specifically, even when a wiring can be formed, the wiring may be not practical due to a high resistance.

According to a technique described in Patent Literature 1, a substance having an ion exchange capacity can be added to a conductive paste using nano-scale silver particles to separate an organic protective film from the surface of each silver particle. Further, it is described that a wiring having a volume resistivity of 4 to 10 $\mu\Omega\cdot$cm can be obtained even by a heat treatment at 150°C for about 10 minutes. However, the disclosed technique is required to use a special coating method such as dry-on-wet or wet-on-wet, and therefore is not suitable for formation of a complex fine wiring.

Patent Literature 2 discloses a conductive paste which contains a dibasic acid having a side chain of an alkyl group or a dibasic acid having an alicyclic structure and is made of an epoxy resin and a phenol resin. Further, Patent Literature 2 describes that the dibasic acid in the conductive paste functions to remove an oxide film on the surface of each silver particle and a wiring having a volume resistivity of 17 to 25 $\mu\Omega\cdot$cm can be obtained by a heat treatment at 180°C for 10 minutes. However, the technique described in Patent Literature 2 does not cause the conductive paste to express sufficient conductivity by a heat treatment at a temperature lower than 150°C.

Patent Literature 3 discloses a joining method using nanoparticles coated with a carboxylic acid, amines, or the like, and silver oxide. Patent Literatures 4 and 5 disclose a method for forming a conductive paste using nano-scale silver particles coated with a carboxylic acid.

Citation List

Patent Literature

Patent Literature 1: Japanese Patent Application Laid-Open No. 2010-132736
Patent Literature 2: Japanese Patent Application Laid-Open No. 2009-298963
Patent Literature 3: Japanese Patent Application Laid-Open No. 2008-166086
Patent Literature 4: Japanese Patent Application Laid-Open No. 2010-132736
Patent Literature 5: Japanese Patent Application Laid-Open No. 2010-153184

## Summary

### Technical Problem

In particular, when a substrate having a low heat resistance is used, a heat treatment at approximately 120°C at which deformation does not take place is desirable. Therefore, a conductive paste in which conductive particles are brought into contact with one another and sintered at a heating temperature of about 120°C to express conductivity has a high utility value, and can be used for various applications. However, the conventional techniques described above cannot provide a conductive paste capable of forming a conductive film having a sufficiently low resistance in practical terms by a treatment at such low temperatures.

It is desirable to provide a paste achieving a low resistance regardless of the type of resin used for the conductive paste. This enables flexible design of a paste according to purposes, and an increase of fields to which the paste could be applied is expected.

In view of such requests, the present invention has been completed. The content disclosed herein proposes a conductive film which can be formed by a heat treatment at low temperatures of about 120°C and exhibits a low volume resistivity. Specifically, even when a resin as a component forming a conductive paste is a thermosetting resin or a thermoplastic resin, the content shows the conductive paste capable of forming a conductive film exhibiting a low resistance under conditions such as a low-temperature treatment without consideration of difference between the resins.

### Solution to Problem

A specific example of a conductive paste capable of forming a conductive film according to the present invention is a conductive paste containing silver particles coated with an organic substance having 2 to 6 carbon atoms, a dispersion medium, a resin, and a dicarboxylic acid having 2 to 8 carbon atoms.

In the above-described configuration, the organic substance having 2 to 6 carbon atoms is preferably a substance derived from a carboxylic acid. The substance derived from a carboxylic acid, used herein, is an organic substance composed of a carboxylic acid or a derivative thereof. The "derivative" means a compound of which the main structure has a carboxylic acid structure having 2 to 6 carbon atoms and some parts of the molecule are substituted with other functional groups.

The amount of dicarboxylic acid to be added to the conductive paste having the above-described configuration may fall within a range of 0.01 to 2.0% by mass with respect to the total mass of the conductive paste.

It is more suitable that the conductive paste having the above-described configuration further contains a dispersant.

As a resin used for the conductive paste having the above-described configuration, a thermosetting resin, a thermoplastic resin, or a mixture thereof can be used.

A wiring formed by subjecting the conductive paste having the above-described configuration to a heat treatment has a structure expressing conductivity by bringing silver particles into contact with one another or sintering them.

A conductive film is obtained by firing the conductive paste having the above-described configuration at 120°C for 60 minutes in the air, wherein, when the L*a*b* color space is used, the conductive film has an a* value of 2.0 or less.

Further, a method for forming a conductive wiring of the present invention includes applying the above-described conductive paste to a substrate, and subjecting the conductive paste to a heat treatment at 100 to 200°C in the air or an inert atmosphere to convert the conductive paste into a metal film.

### Advantageous Effects of Invention

When the configuration of the conductive paste is used, particularly a dicarboxylic acid is added to the configuration, a wiring having a very practical conductivity can be formed even by a heat treatment at temperatures lower than the conventional conductive paste. Further, a resin used for the conductive paste may be a thermosetting resin, a thermoplastic resin, or a mixture thereof. In other words, it is confirmed that the kind of used resin is not particularly limited. Therefore, the conductive paste can flexibly meet an application to which the conductive paste is tried to be applied, and the fields in which the conductive paste is used can dramatically increase.

### Brief Description of Drawings

Fig. 1 includes TG graphs for a sintering promoting component (sintering promoter), a silver nanoparticle, and a mixture thereof.

Fig. 2 is a view showing volume resistivities when malonic acid as a sintering promoting component is and is not added to each resin. However, cases wherein a polyurethane resin, and a polyester resin, and a mixed resin of a polyurethane resin and an isocyanate resin are used and the sintering promoting component is not added are over the range, and therefore are represented as "1,000 $\mu\Omega\cdot$cm" for the sake of convenience.

Fig. 3 is a view showing a relation of a volume resistivity and a ratio of the amount of an additive (sintering promoting component) to the amount of the component of an organic substance coating a silver nanoparticle.

Fig. 4 is a graph showing a relation of an a* value when the color difference of a fired film obtained by applying a conductive paste and subjecting the paste to a heat treatment at 120°C for 60 minutes in the air is represented by the L*a*b* color space and a volume resistivity.

Description of Embodiments

As a conductive metal particle, gold, silver, copper, nickel, or aluminum can be used. From the viewpoints of cost and reliability, silver is most frequently used. For this reason, an example using a silver particle as a conductive particle will be specifically described in the description, but this does not prevent the present invention from being applied to substances other than silver.

<Silver nanoparticle>

As nano-scale silver particles used in the present invention, particles having an average primary particle diameter to be determined from a transmission electron microscope (TEM) photograph of 200 nm or less, preferably 1 to 150 nm, and more preferably 10 to 100 nm are used. A silver particle having such a particle diameter is referred to as a silver nanoparticle. When the silver nanoparticle is used, a conductive paste using a resin is subjected to a heat treatment even at low temperatures of about 120°C to form a conductive film having a high conductivity.

The average primary particle diameter is evaluated by a transmission electron microscope as follows. 2 parts by mass of washed silver nanoparticles are added to a mixed solution of 96 parts by mass of cyclohexane and 2 parts by mass of oleic acid, and dispersed by ultrasonic wave. The dispersion solution is added dropwise to a copper microgrid with a supporting film, and dried to produce a TEM sample. The particles are observed on the TEM sample microgrid in a bright field under an accelerating voltage of 100 kV by using a transmission electron microscope (Model: JEM-100CXMark-II manufactured by JEOL Ltd.). This image is enlarged to a photograph magnification of 300,000, and then is used.

To determine a particle diameter from the photograph, the particle may be directly measured by a vernier caliper, or the particle diameter may be calculated by an image analysis software. In the TEM photograph, at least 200 independent particles are measured, and the average primary particle diameter thereof is calculated as the number average value.

The silver content in the silver nanoparticles coated with the organic coating substance is determined by the following procedures. 0.5 g or more of sample (silver nanoparticles coated with an organic coating substance) is weighed in an ashtray for measurement of ash content and the temperature thereof is increased to 700°C at a rate of about 10°C/min in a muffle furnace (FO310 manufactured by Yamato Scientific Co., Ltd.) to remove the organic coating substance on the surface of the silver nanoparticles. After then, when the temperature inside the furnace reaches 500°C or lower by natural cooling, the ashtray is taken out, and cooled to normal temperature in a desiccator. The silver content is calculated by comparison of the weight of the cooled sample with the weight of the sample before the heat treatment. The organic substance coating the surface can be found, for example, by detecting a gas component under an inert atmosphere by a thermal analysis device such as TG-MS and GC-MS.

The silver nanoparticles used in the present invention have the above-described average primary particle diameter and the surfaces thereof are coated with an organic substance. Specifically, as such an organic substance, an organic substance composed of a carboxylic acid having 2 to 6 carbon atoms or a derivative thereof can be suitably used. Specific examples thereof may include, but not limited to, hexanoic acid (caproic acid), pentanoic acid (valeric acid), butanoic acid (butyric acid), and propanoic acid (propionic acid), which are saturated fatty acids, and sorbic acid and maleic acid, which are unsaturated fatty acids.

Among them, when the surfaces of silver nanoparticles are coated with hexanoic acid, adipic acid, or sorbic acid, the production is easy, and the silver nanoparticles coated with the organic substance can be obtained as powder. It is preferable that a form to be provided be powder since blending for formation of a conductive paste like the present invention becomes easy. Further, the particles the surfaces of which are coated with such an organic substance can be aggregated and easily collected by filtration while the form of primary particles is kept. The aggregate has a size enough to be collected by JIS P3801 No. 5C, that is, a size of 2.5 $\mu$m or more.

Since a clear filtrate can be obtained by filtration and collection, it is considered that an aggregated (secondary) particle diameter of 2.5 $\mu$m as described above is different from the average secondary particle diameter ($D_{50}$) of silver

nanoparticles. This is because when the above-described particle diameter is $D_{50}$, there may be many aggregates which are not filtrated through the filter paper and pass through it. Therefore, it may be interpreted that the above-described aggregated (secondary) particle diameter is not an average value and the silver nanoparticles may become aggregates having at least about 2.5 $\mu$m. In addition, the aggregates can be collected as a dried powder by a drying process at low temperatures (lower than 100°C).

In a conductive paste, silver nanoparticles coated with a plurality of organic substances may be used, or silver nanoparticles having different average primary particle diameters may be used in combination.

<Silver microparticle>

The present inventors have found that when the surface of a silver particle having a large particle diameter is coated with an organic substance, the silver particle has the same effect as a silver nanoparticle. Silver particles having an average particle diameter ($D_{50}$) of 0.5 to 20 $\mu$m are referred to as silver microparticles against silver nanoparticles. In a specific aspect, the surfaces of particles are coated with an organic substance including a carboxylic acid having 2 to 6 carbon atoms or a derivative thereof as an organic substance used for coating. Examples of the organic substance used for coating may include, but not limited to, hexanoic acid (caproic acid), pentanoic acid (valeric acid), butanoic acid (butyric acid), and propanoic acid (propionic acid), which are saturated fatty acids, and sorbic acid and maleic acid, which are unsaturated fatty acids.

Silver microparticles used in the present invention may be produced so as to be coated with an organic substance at a manufacturing stage. Alternatively, commercially available silver microparticles may be coated with the above-described organic substance by a substitution method.

<Dispersion medium>

In a conductive paste according to the present invention, silver particles (silver nanoparticles or silver microparticles) are dispersed in a dispersion medium. It is preferable that the dispersion medium used in this case be a polar solvent.

In particular, use of a solvent having compatibility with various resins does not cause any problems. Water, or an ester-based, an ether-based, a ketone-based, an ether ester-based, an alcohol-based, a hydrocarbon-based, or an amine-based organic solvent is preferably used.

Specific examples thereof may include diols such as octanediol, alcohol, polyol, glycol ether, 1-methylpyrrolidinone, pyridine, terpineol, butyl carbitol, butyl carbitol acetate, texanol, phenoxypropanol, diethylene glycol monobutyl ether, diethylene glycol monobutyl ether acetate, γ-butyrolactone, ethylene glycol monomethyl ether acetate, ethylene glycol monoethyl ether acetate, methoxybutyl acetate, methoxypropyl acetate, diethylene glycol monoethyl ether acetate, ethyl lactate, and 1-octanol.

In particular, since a conductive paste is usually used to form a circuit by printing, a solvent having a low volatility and a high boiling point is preferably used during printing, and terpineol, butyl carbitol acetate, or octanediol is more preferably used. Further, a plurality of solvents may be used in combination. The amount of the solvent is preferably 60% by mass or less, and more preferably 50% by mass or less, with respect to the total amount of a resin and a metal component.

<Dispersant component>

To the past according to the present invention, a dispersant may be added. Such a dispersant is used to secure the independence of particles in the conductive paste. The dispersant is not limited as long as it has affinity with the surface of particles and affinity with a dispersion medium, and may be a commercially available product. Not only a single kind of dispersant but also a plurality of kinds of dispersants may be used. The amount of the dispersant to be added is 3.0% by mass or less, preferably 1.0% by mass or less, and more preferably 0.5% by mass or less, with respect to the total amount of the silver including silver nanoparticles and silver microparticles.

Typical examples of a dispersant to be suitably used may include a low molecular weight anionic compound such as a fatty acid salt (soap), a salt of an α-sulfo fatty acid ester (MES), an alkylbenzenesulfonate (ABS), a linear-alkylbenzenesulfonate (LAS), an alkylsulfate (AS), a salt of an alkyl ether sulfate (AES), and alkyl sulfuric acid triethanol; a low molecular weight nonionic compound such as fatty acid ethanolamide, polyoxyethylene alkyl ether (AE), polyoxyethylene alkyl phenyl ether (APE), sorbitol, and sorbitan; a low molecular weight cationic compound such as an alkyltrimethylammonium salt, dialkyldimethylammonium chloride, and alkyl pyridinium chloride; a low molecular weight amphoteric compound such as alkylcarboxylbetaine, sulfobetaine, and lecithin; a formalin condensate of naphthalene sulfonate; polystyrene sulfonate; polyacrylate; a salt of copolymer of a vinyl compound and a carboxylic acid-based monomer; a macromolecular aqueous dispersant typified by carboxymethyl cellulose, and polyvinyl alcohol; a macromolecular nonaqueous dispersant such as a partial alkyl ester of polyacrylic acid, and polyalkylene polyamine; and a macromolecular cationic dispersant such as polyethyleneimine, and an aminoalkyl methacrylate copolymer. However, the dispersant does not exclude a compound having a structure other than the structures exemplified herein as long as it can be suitably applied to the particles of the present invention.

Specific names of the dispersant are known as follows, but the use of a product other than those described below is not excluded as long as the product has the properties described above. Examples thereof may include BEAULIGHT LCA-H and LCA-25H available from Sanyo Chemical Industries, Ltd., FLOWLEN DOPA-15B available from KYOEISHA CHEMICAL CO., LTD., SOLPLUS AX5, SOLSPERSE 9000, and SOLTHIX 250 available from The Lubrizol Corporation, EFKA4008 available from EFKA ADDITIVES, AJISPER PA111 available from Ajinomoto Fine-Techno Co., Inc., TEXAPHOR-UV21 available from Cognis Japan Ltd., DisperBYK2020 and BYK220S available from BYK Japan KK, DISPARLON 1751N and HIPLAAD ED-152 available from Kusumoto Chemicals, Ltd., FTX-207S and FTERGENT 212P available from NEOS COPANY LIMITED, AS-1100 available from Toagosei Co., Ltd., KAOCER 2000, KDH-154, MX-2045L, HOMOGENOL L-18, and RHEODOL SP-010V available from Kao Corporation, EPAN U103, SHALLOL DC902B, NOIGEN EA-167, and PLYSURF A219B available from DAI-ICHI KOGYO SEIYAKU CO., LTD., MEGAFAC F-477 available from DIC Corporation, SILFACE SAG503A, and Dynol 604 available from Nissin Chemical Industry Co., Ltd., SN-SPERSE 2180 and SN-LEVELLER S-906 available from SAN NOPCO LIMITED, and S-386 available from AGC SEIMI CHEMICAL CO., LTD.

In addition to the dispersant, various additives may be added to improve stability and printing property of the paste. Examples thereof may include a leveling agent, a viscosity modifier, a rheology controlling agent, an antifoaming agent, and a dripping preventing agent.

<Resin>

As a resin to be added to the conductive paste of the present invention, a thermosetting resin, or a thermoplastic resin which is widely known, or both the resins can be used. The amount of the resin to be added may be 2 to 20% by mass, and preferably 2 to 15% by mass, with respect to the total amount of the amount of the resin and the total amount of the silver including silver nanoparticles and silver microparticles. When the amount of a resin to be added is too large, the resin is left in an excess amount in a wiring after firing to decrease conductivity. Therefore, it is not preferable. On the other hand, when it is small, adhesion between a wiring and a substrate cannot be secured. Therefore, it is necessary that the addition amount is at least about 2% by mass.

(Thermoplastic resin)

In the present invention, any known thermoplastic resins can be used. In particular, it is preferable that an acrylic resin, a polyester resin, or a polyurethane resin be added. As a generally known resin, the following resins are known. However, the use of a resin other than those described below is not excluded as long as the resin has the properties described above.

A polyurethane resin is not particularly limited as long as it is a commercially available thermoplastic urethane resin. Examples thereof may include a thermoplastic urethane resin which has a polyol component and an organic polyisocyanate as essential components, and is obtained by polymerization using a chain-elongating agent, a terminator, and the like, as optional components.

Examples of polyisocyanate used herein may include hexamethylene diisocyanate (HDI), lysine isocyanate (LDI), isophorone diisocyanate (IPDI), xylylene diisocyanate (XDI), hydrogenated XDI ($H_6$-XDI), hydrogenated MDI ($H_{12}$-MDI), trans-cyclohexane-1,4-diisocyanate, tetramethylxylene diisocyanate (TMXDI), 1,6,11-undecane triisocyanate, 1,8-diisocyanate-4-isocyanate methyloctane, 1,3,6-hexamethylene triisocyanate, bicycloheptane triisocyanate, trimethylhexamethylene diisocyanate (TMDI), and derivatives thereof. Among them, HDI, IPDI, $H_6$-XDI, and $H_{12}$-MDI are suitable in terms of low yellowing properties.

Further, it is preferable that a polyol used with the above-described polyisocyanate be a polyol having a low crystallinity. Specific examples thereof may include polyethyleneadipate (PEA), polybutyleneadipate (PBA), polycarbonate (PCD), polytetramethylene glycol (PTMG), polycaprolactone polyester (PCL), and polypropylene glycol (PPG).

An acrylic resin represents a resin having a (meth)acrylate unit and/or a (meth)acrylic acid unit as a constitutional unit. The acrylic resin may be a resin having a constitutional unit derived from (meth)acrylate or a derivative of (meth)acrylic acid.

Examples of the (meth)acrylate unit used herein may include constitutional units derived from monomers such as methyl (meth)acrylate, ethyl (meth)acrylate, n-propyl (meth)acrylate, n-butyl (meth)acrylate, t-butyl (meth)acrylate, n-hexyl (meth)acrylate, cyclohexyl (meth)acrylate, 2-ethylhexyl (meth)acrylate, benzyl (meth)acrylate, dicyclopentanyloxyethyl (meth)acrylate, dicyclopentanyl (meth)acrylate, chloromethyl (meth)acrylate, 2-chloroethyl (meth)acrylate, 2-hydroxyethyl (meth)acrylate, 3-hydroxypropyl (meth)acrylate, 2,3,4,5,6-pentahydroxyhexyl (meth)acrylate, 2,3,4,5-tetrahydroxypentyl (meth)acrylate, methyl 2-(hydroxymethyl)acrylate, ethyl 2-(hydroxymethyl)acrylate, and methyl 2-(hydroxyethyl)acrylate.

Examples of the (meth)acrylic acid unit may include constitutional units derived from monomers such as acrylic acid, methacrylic acid, crotonic acid, 2-(hydroxymethyl)acrylic acid, and 2-(hydroxyethyl)acrylic acid.

As a polyester resin, any generally known resins can be used. As a method for producing the same, there are condensation polymerization of a low molecular diol with a polycarboxylic acid or an ester-forming derivative thereof (acid anhydride, lower alkyl (having 1 to 4 carbon atoms) ester, and acid halide) and ring-opening polymerization of lactone monomer using a low molecular diol as an initiator. Further, use of mixture of two or more kinds thereof is also not prevented.

(Thermosetting resin)

In the present invention, any known thermosetting resins can be used. The thermosetting resin can be specifically selected from a phenol resin, an epoxy resin, an unsaturated polyester resin, an isocyanate compound, a melamine resin, a urea resin, and a silicone resin. Here, an epoxy resin and a phenol resin will be described.

As an epoxy resin according to the present invention, an epoxy resin having an effect of improving the weatherability of a coated film is used. Specifically, a mono-epoxy compound, a polyvalent epoxy compound, or a mixture thereof may be used as an epoxy resin. Examples of the mono-epoxy compound may include butyl glycidyl ether, hexyl glycidyl ether, phenyl glycidyl ether, allyl glycidyl ether, p-tert-butyl phenyl glycidyl ether, ethylene oxide, propylene oxide, p-xylyl glycidyl ether, glycidyl acetate, glycidyl butyrate, glycidyl hexoate, and glycidyl benzoate.

Examples of the polyvalent epoxy compound may include a bisphenol-type epoxy resin obtained by glycidylating bisphenols, such as bisphenol A, bisphenol F, bisphenol AD, bisphenol S, tetramethylbisphenol A, tetramethylbisphenol F, tetramethylbisphenol AD, tetramethylbisphenol S, tetrabromobisphenol A, tetrachlorobisphenol A, and tetrafluorobisphenol A; an epoxy resin obtained by glycidylating other dihydric bisphenols, such as biphenol, dihydroxynaphtalene, and 9,9-bis(4-hydroxyphenyl)fluorene; an epoxy resin obtained by glycidylating trisphenols, such as 1,1,1-tris(4-hydroxyphenyl)methane, and 4,4-(1-(4-(1-(4-hydroxyphenyl)-1-methylethyl)phenyl)ethylidene)bisphenol; an epoxy resin obtained by glycidylating tetrakisphenols, such as 1,1,2,2,-tetrakis(4-hydroxyphenyl)ethane; a novolac-type epoxy resin obtained by glycidylating novolacs, such as phenol novolac, cresol novolac, bisphenol A novolac, brominated phenol novolac, and brominated bisphenol A novolac; an epoxy resin obtained by glycidylating polyhydric phenols; an aliphatic ether-type epoxy resin obtained by glycidylating a polyhydric alcohol, such as glycerol and polyethyleneglycol; an ether ester-type epoxy resin obtained by glycidylating a hydroxycarboxylic acid, such as p-oxybenzoic acid and $\beta$-oxynaphthoic acid; an ester-type epoxy resin obtained by glycidylating a polycarboxylic acid, such as phthalic acid and terephthalic acid; a glycidyl-type epoxy resin such as a compound obtained by glycidylating an amine compound, such as 4,4-diaminodiphenylmethane and m-aminophenol, and an amine-type epoxy resin including triglycidyl isocyanurate, and an alicyclic epoxide such as 3,4-epoxycyclohexylmethyl-3',4'-epoxycyclohexene carboxylate.

Among the epoxy resins, a polyvalent epoxy compound is preferable in terms of the enhanced shelf stability. Among the polyvalent epoxy compounds, a glycidyl-type epoxy resin is preferable in terms of the productivity being significantly high. Further, an epoxy resin obtained by glycidylating polyhydric phenols is preferable since the adhesion and heat resistance during hardening are excellent. A bisphenol-type epoxy resin is more preferable, and an epoxy resin obtained by glycidylating bisphenol A and an epoxy resin obtained by glycidylating bisphenol F are particularly preferable.

It is preferable that the form of a resin be liquid. It is preferable that the epoxy equivalent be 300 or less. When the epoxy equivalent is more than 300, the resistance after formation of a wiring is increased and the composition becomes solid. Therefore, the composition is difficult to handle during use. Accordingly, this is not preferable.

Examples of a thermosetting phenol resin may include a liquid novolac-type phenol resin, a cresol novolac resin, a dicyclopentadiene-type phenol resin, a terpene-type phenol resin, a triphenolmethane-type resin, and a phenolaralkyl resin.

<Sintering promoting component>

The conductive paste according to the present invention is particularly characterized that in addition to the above-described components, an organic substance is added as a sintering promoting component. Specifically, a dicarboxylic acid having at least two carboxyl groups may be selected. When a substance having such a configuration is selected and added, the conductive paste composed of silver nanoparticles or silver microparticles, coated with an organic substance, is sintered between the silver nanoparticles or silver microparticles even by heat treatment at low temperatures. Therefore, a conductive film expressing a high conductivity can be formed.

Examples of the above-described sintering promoting component may include oxalic acid, malonic acid, succinic acid, and glutaric acid, which have a dicarboxylic acid structure having 2 to 8 carbon atoms. As the total number of carbon atoms in the structure is increased, the activity is decreased. In this case, when a conductive paste containing silver nanoparticles or silver microparticles is subjected to a heat treatment at low temperatures, a conductive film expressing a high conductivity is unlikely to be formed. This is because sintering between the silver nanoparticles or silver microparticles is unlikely to occur by heat treatment at low temperatures. Further, when a substance having too many carbon atoms is used, the added substance itself suppresses sintering or remains in the film. Thus, a high conductivity is not easily expressed, and this is not preferable.

As a dicarboxylic acid, it is preferable that the total number of carbon atoms in the structure be smaller. Specifically, the total number of carbon atoms of dicarboxylic acid is 2 to 8, preferably 2 to 7, and more preferably 2 to 5. The amount of such a component is 0.01 to 2.0% by mass, and preferably 0.1 to 1.5% by mass, with respect to the total weight of the conductive paste. In particular, a sintering promoting action was confirmed by the addition of malonic acid or glutaric acid.

The amount of dicarboxylic acid in the conductive paste can be confirmed by using a high performance liquid chromatography (HPLC) or a polymer reversed phase chromatography, for example.

<Production of conductive paste>

The conductive paste according to the present invention is produced by using silver nanoparticles or silver microparticles the surfaces of which are coated with an organic substance having 2 to 8 carbon atoms, as described above. A method of producing the silver nanoparticles or silver microparticles, having such a configuration is not particularly limited. For example, surfaces of known silver nanoparticles or silver microparticles can be substituted by an organic substance having carbon atoms within the range.

The silver nanoparticles or silver microparticles coated with an organic substance, a sintering promoting component having the above properties, and if necessary, a dispersant, and a resin, are mixed in the above-mentioned polar solvent. The mixture is then introduced into a defoaming kneader, and a kneaded substance including the components is formed. After then, a mechanical dispersion processing is optionally performed to form a conductive paste.

In the above-described mechanical dispersion processing, any known method can be used under a condition in which the silver particles are not significantly modified. Specific examples thereof may include an ultrasonic dispersion, a disper, a three-roll mill, a ball mill, a bead mill, a two-axis kneader, and a planetary centrifugal mixer. The methods may be used alone or consecutively in combination of two or more.

<Evaluation of conductive film>

(Printing method)

The produced conductive paste was printed by a screen printing machine or a metal mask, and fired. The conductive film was then evaluated. The viscosity was adjusted by a rheometer (RheoStress 600 manufactured by HAAKE) and a cone having a diameter of 35 mm and an angle of 2°. While the rate of shear is changed into 1.57, 3.13, 6.27, 15.67, 31.34, 62.70, and 156.7 [1/s] under a condition of a gap of 0.105 mm and a temperature of 25°C during measurement, the viscosities after 20 seconds are measured at each rate of shear. Among them, the viscosity is a value when the rate of shear is 15.67 [1/s]. The conductive pastes used in Examples and Comparative Examples were produced so that the viscosity is 30 Pa·s to prevent printing failures such as blur. The amounts of conductive pastes to be mixed are as shown in Tables 1 to 3.

(Screen printing)

The conductive paste was printed on a polyethylene terephthalate film (Lumirror 75S10 available from Toray Industries, Inc.) in a pattern of 300 $\mu$m in line width by a screen having a film thickness of 34 $\mu$m. The obtained printing substrate was subjected to a heat treatment at 120°C for 60 minutes in the air in a firing furnace (DKM400 manufactured by Yamato Scientific Co., Ltd.), and then the volume resistivity was measured.

(Metal mask printing)

The conductive paste was solid printed on an alumina in a pattern of 10-mm square by a metal mask having a film thickness of 30 $\mu$m. The obtained printing substrate was subjected to a heat treatment at 120°C for 60 minutes in the air by a firing furnace (DKM400 manufactured by Yamato Scientific Co., Ltd.), and then the volume resistivity was measured.

<Measurement of volume resistivity>

(Wiring)

The line resistance of a wiring formed on a substrate by screen printing was measured by a two-terminal resistivity meter (mΩ HiTESTER 3540 manufactured by HIOKI E.E. CORPORATION). The thickness of the conductive film was measured by a surface roughness tester (SURFCOM 1500D manufactured by TOKYO SEIMITSU CO., LTD.). The volume resistivity of the wiring was finally determined in accordance with the following equation (1).

$$\text{Volume resistivity } (\mu\Omega\cdot\text{cm}) = \text{actually measured resistance } (\Omega) \times$$
$$\text{film thickness } (\mu\text{m}) \times \text{line width } (\mu\text{m}) \ / \ \text{line length } (\mu\text{m}) \times 10^2$$
$$(1)$$

(Solid film)

The conductive paste was printed on a substrate with a metal mask. The surface resistance of the formed conductive film having a pattern of 10-mm square was measured by a four-terminal resistivity meter (LORESTA GP MCP-T160 manufactured by Mitsubishi Chemical Corporation). The thickness of the conductive film was measured by a surface roughness tester (SURFCOM 1500D manufactured by TOKYO SEIMITSU CO., LTD.). The volume resistivity of the solid film having a pattern of 10-mm square was finally determined in accordance with the following equation (2).

$$\text{Volume resistivity } (\mu\Omega\cdot\text{cm}) = \text{surface resistance } (\Omega/\text{square}) \times$$
$$\text{film thickness } (\mu\text{m}) \times 100 \quad (2)$$

<Color difference>

The conductive paste was solid printed on a glass substrate (EAGLE XG) in a size of 2.0 to 2.5 cm in length and 1.5 to 2.0 cm in width, and fired at 120°C for 60 minutes in the air to form a film. The color specification of the film was measured. The color difference was measured by a color difference meter (SQ-2000 manufactured by NIPPON DENSHOKU INDUSTRIES CO., LTD.). The results of the measurement are represented by the L*a*b* color space. The conductive paste according to the present invention is particularly characterized by an a* value when the color difference is represented by the L*a*b* color space. When an additive including a dicarboxylic acid is not added, the a* value is more than 2.0, and when it is added, the a* value is 2.0 or less.
Therefore, when the a* value is more than 2.0, the resistance of the conductive film is extremely high. On the other hand, when it is 2.0 or less, the resistance is low. In the present invention, the complete conductive film containing a dicarboxylic acid and having an excellent conductivity can be judged by the hue of the conductive film.

(Evaluation of crystal growth by firing)

The conductive paste was printed on a copper hull cell panel in a pattern of 10-mm square, and fired at 120°C for 60 minutes in the air to form a film. The crystallite diameter of the film was measured by X-ray diffraction, whereby the degree of growth of crystal was confirmed. At that time, the measurement was performed using an X-ray diffratometer (RINT-2100 manufactured by Rigaku Corporation). The measurement was performed using a cobalt bulb as a bulb at a tube voltage of 40 kV and a tube current of 30 mA. The degree of growth of crystallite was calculated by comparison with the size of crystallite diameter. In particular, since a diffraction plane was Ag (1 1 1), the measurement was performed in a range 2θ of 40 to 50° (scanning speed: 0.167°/min). The crystallite diameter was calculated in accordance with Scherrer method.

(Evaluation of conductive paste, and the like, by TG)

TG measurement was performed using a TG/DTA device (TG/DTA 6300 manufactured by Seiko Instruments Inc.) by increasing the temperature of 20 mg of powder or conductive paste in the air from normal temperature to 700°C at a temperature increasing rate of 10°C/min.

EXAMPLES

A case using silver nanoparticles shown in Table 1 will be first described.

<Example 1>

(Synthesis example of silver nanoparticle)

As a production example of particles shown in Examples, production of silver nanoparticles coated with sorbic acid is exemplified. In a 500-mL beaker, 13.4 g of silver nitrate (available from TOYO KAGAKU, INC.) was dissolved in 72.1 g of pure water to prepare a silver solution.
1.34 L of pure water was put in a 5-L beaker, and nitrogen was bubbled through the water for 30 minutes to remove dissolved oxygen and at the same time, the temperature was increased to 60°C. 17.9 g of sorbic acid (available from Wako Pure Chemical Industries, Ltd.) was added. Then, 2.82 g of 28% aqueous ammonia (available from Wako Pure Chemical Industries, Ltd.) was added to adjust the pH. The addition of aqueous ammonia initiated a reaction. Five minutes after the initiation of reaction, 5.96 g of hydrous hydrazine (purity: 80%, available from Otsuka Chemical Co., Ltd.) was added under stirring.
Nine minutes after the initiation of reaction, the prepared silver solution was added to cause a reaction. The resultant was then aged for 30 minutes to prepare silver nanoparticles coated with sorbic acid. The nanoparticles were filtrated through a filter paper No. 5C, and washed with pure water to obtain an aggregate of silver nanoparticles. As such an aggregate of silver nanoparticles, one obtained by appropriately substituting an organic substance on the surface of the particles, or one directly obtained by using the procedure described above was used. The aggregate of silver nanoparticles was dried at 80°C for 12 hours in the air by a vacuum drier, to obtain a dried powder of aggregate of silver nanoparticles.

(Production of conductive paste)

1.3 g of butyl carbitol acetate (available from Wako Pure Chemical Industries, Ltd.), 22.3 g of thermoplastic polyurethane resin, UREARNO 8001 (available from ARAKAWA CHEMICAL INDUSTRIES, LTD.), 0.35 g of macromolecular pigment dispersant, AJISPER PA-111 (available from Ajinomoto Fine-Techno Co., Inc.), and 0.14 g of malonic acid (available from Wako Pure Chemical Industries, Ltd.) were mixed in 70 g of dried powder of aggregate of silver nanoparticles coated with sorbic acid (average primary particle diameter: 100 nm) which had been obtained.
The resulting mixture was passed through a three roll mill (M-80S manufactured by EXAKT Apparatebaus) five times to prepare a conductive paste. While the viscosity of the conductive paste was confirmed, a dispersion medium was added to the prepared conductive paste to adjust the viscosity to 30 Pa·s which was suitable for printing. As a result of the viscosity adjustment, the total amount of finally added butyl carbitol acetate was 8.9 g. The resulting conductive paste was printed on a substrate, and subjected to a heat treatment under a condition of 120°C and 60 minutes (referred to as at 120°C for 60 minutes) to form a conductive film. The volume resistivity of the conductive film after treatment at 120°C for 60 minutes was 24 $\mu\Omega$·cm.
The crystallite diameter measured by X-ray diffraction was 37.65 nm. The fired film was yellowish. When the color difference of the film was determined by a color difference meter, L* was 60.89, a* was 1.04, and b* was 9.31. When the form of the fired film was observed by SEM, lumps which had been originally in a particulate shape adhered together by twos and threes to each form a collection. This confirmed that even at low temperatures of 120°C, the form of primary particles was not kept and particle growth occurred.

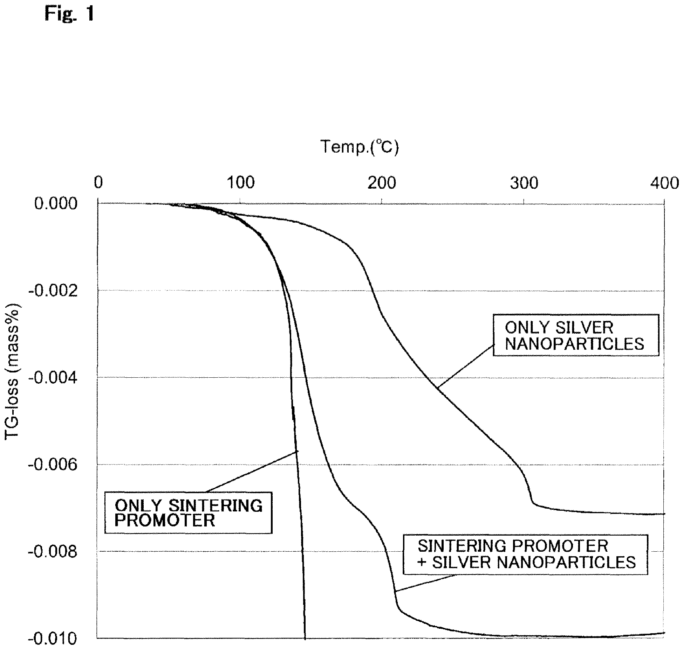

Fig. 1 shows a comparison of TG diagrams of the original powder (silver nanoparticles coated with sorbic acid) and one obtained by adding an additive (sintering promoter: malonic acid) to the original powder. The additive was mixed in the original powder in an amount of 0.2% by mass with respect to the original powder. 28 mg of the mixture of the original powder and the additive was weighed and evaluated. The vertical axis represents loss weight (%) and the horizontal axis represents temperature. As seen in Fig. 1, the TG diagram of the original powder (described as "only silver nanoparticles") and the TG diagram during addition of the additive (described as "sintering promoter + silver nanoparticles") are largely different, and a temperature lowering of 50°C or higher is seen at a temperature at which a decrease in weight converges.

<Comparative Example 1>

The same procedure as in Example 1 was repeated except that malonic acid was not added as an additive in Example 1. Physical properties of the resulting fired film are shown together in Table 1.
The crystallite diameter measured by X-ray diffraction was 29.90 nm. The fired film was slightly reddish. When the color difference of the film was determined by a color difference meter, L* was 63.54, a* was 4.04, and b* was 4.05. When the form of the fired film was observed by SEM, it was confirmed that the configuration of fine particles was kept as they were. This shows that the configuration of fine particles is kept and particle growth does not promote since the temperature is a low temperature of 120°C.

<Examples 2 to 5>

The same procedure as in Example 1 was repeated except that the addition amount of malonic acid as an additive was changed into the amounts shown in Table 1. Physical properties of the resulting fired film are shown together in Table 1.

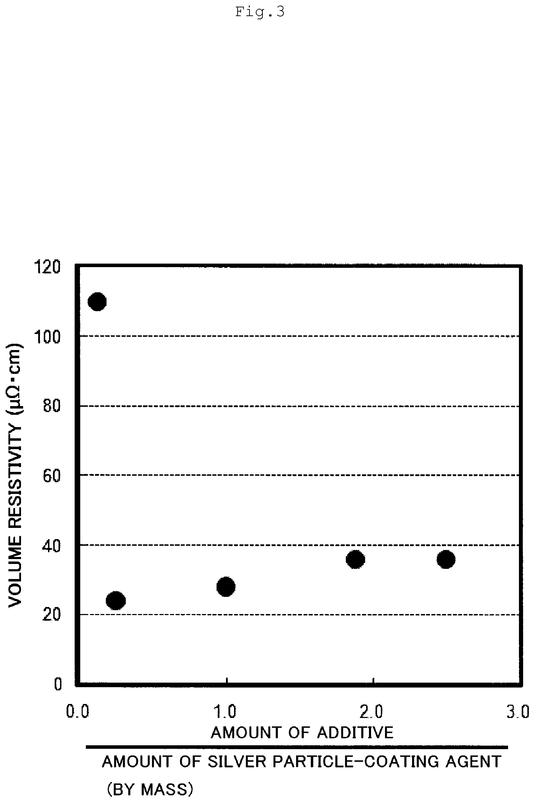

Fig. 3 shows a relation between the ratio of the addition amount of the additive to the existing amount of the coating agent which coats silver nanoparticles and the volume resistivity in Examples 1 to 5. In Fig. 3, the vertical axis represents volume resistivity ($\mu\Omega\cdot$cm) and the horizontal axis represents a ratio (by mass) of the amount of the additive to the amount of the silver particle-coating agent. The values are shown in Table 1. As shown in Fig. 3, when the ratio of the amount of the additive to the amount of the silver particle-coating agent is 0.25 (proportion: 25%) or more, the volume resistivity is stabilized to a very low value (36 $\mu\Omega\cdot$cm or less).

The ratio of the addition amount of the additive to the amount of the coating agent which coats silver nanoparticles in Fig. 3 can be represented by the addition amount of the additive (g)/(the addition amount of the silver nanoparticles (g) $\times$ the ratio of the coating agent to the silver particles). The ratio of the coating agent of the silver nanoparticles is the ratio of the organic substance determined by the above-described measurement of ash content, and is represented by an equation: the ratio of the coating agent = 1 - (the remained weight after treatment of ash content (g) / the weight of the sample which is subjected to treatment of ash content (g)) $\times$ 100. Specifically, the ratio of the coating agent in the case of sorbic acid (60 nm) used in Example 1 is 0.8% by mass.

<Examples 6 to 8>

The same procedure as in Example 1 was repeated except that the kind of the silver nanoparticle forming a conductive paste was changed as shown in Table 1 in Example 1. The ratios of the coating agent in the cases of sorbic acid (60 nm), hexanoic acid (20 nm), and butanoic acid (100 nm) were 1.22% by mass, 2.86% by mass, and 0.8% by mass, respectively. Physical properties of the resulting fired film are shown together in Table 1.

<Examples 9 to 10>

The same procedure as in Example 1 was repeated except that the amounts of the silver nanoparticles and malonic acid to be mixed in Example 1 were changed as shown in Table 1. Physical properties of the resulting fired film are shown together in Table 1.

<Examples 11 and 12 and Comparative Examples 2 and 3>

The same procedure as in Example 1 was repeated except that the kinds of the additive to be added in Example 1 were each changed. Physical properties of the resulting fired film are shown together in Table 1.

[Table 1]

| | | | | EXMPL1 | EXMPL2 | EXMPL3 | EXMPL4 | EXMPL5 | COMP. EXMPL1 | EXMPL6 | EXMPL7 | EXMPL8 | EXMPL9 | EXMPL10 | EXMPL11 | EXMPL12 | COMP. EXMPL2 | COMP. EXMPL3 |
|---|---|---|---|---|---|---|---|---|---|---|---|---|---|---|---|---|---|---|
| MIXED COMPONENTS | AMOUNT OF SILVER PARTICLE (g) | SORBIC ACID | 100nm | SPHERICAL | 70.0 | 70.0 | 70.0 | 70.0 | 70.0 | 70.0 | — | — | — | 66.0 | 75.0 | 70.0 | 70.0 | 70.0 | 70.0 |
| | | | 60nm | SPHERICAL | — | — | — | — | — | — | 70.0 | — | — | — | — | — | — | — | — |
| | | HEXANOIC ACID | 20nm | SPHERICAL | — | — | — | — | — | — | — | 70.0 | — | — | — | — | — | — | — |
| | | BUTANOIC ACID | 100nm | SPHERICAL | — | — | — | — | — | — | — | — | 70.0 | — | — | — | — | — | — |
| | AMOUNT OF ADDITIVE (g) | MALONIC ACID | | | 0.14 | 1.40 | 0.07 | 0.56 | 1.05 | — | 0.18 | 0.42 | 0.14 | 0.13 | 0.15 | — | — | — | — |
| | | GLUTARIC ACID | | | — | — | — | — | — | — | — | — | — | — | — | 0.14 | — | — | — |
| | | AZELAIC ACID | | | — | — | — | — | — | — | — | — | — | — | — | — | — | 0.14 | — |
| | | LACTIC ACID | | | — | — | — | — | — | — | — | — | — | — | — | — | — | — | 0.14 |
| | | DIGLYCOLIC ACID | | | — | — | — | — | — | — | — | — | — | — | — | — | 0.14 | — | — |
| | AMOUNT OF ADDITIVE / AMOUNT OF SILVER PARTICLE-COATING AGENT | | | | 0.25 | 2.50 | 0.13 | 1.00 | 1.88 | 0 | 0.21 | 0.21 | 0.25 | 0.25 | 0.25 | 0.25 | 0.25 | 0.25 | 0.25 |
| | AMOUNT OF RESIN (g) | UREARNO 8001 (POLYURETHANE RESIN) | | | 22.3 | 22.3 | 22.3 | 22.3 | 22.3 | 22.3 | 22.3 | 22.3 | 22.3 | 25.4 | 18.4 | 22.3 | 22.3 | 22.3 | 22.3 |
| | AMOUNT OF SOLVENT (g) | BCA (BUTYL CARBITOL ACETATE) | | | 8.9 | 7.7 | 8.3 | 8.9 | 8.9 | 7.3 | 18.1 | 18.7 | 7.2 | 7.9 | 6.7 | 8.3 | 8.8 | 8.6 | 7.7 |
| | AMOUNT OF DISPERSANT (g) | AJISPER PA-111 | | | 0.35 | 0.35 | 0.35 | 0.35 | 0.35 | 0.35 | 0.35 | 0.35 | 0.35 | 0.33 | 0.37 | 0.35 | 0.35 | 0.35 | 0.35 |
| EVALUATION | FILM THICKNESS | μm | | | 3.1 | 2.4 | 2.4 | 2.7 | 2.7 | 2.1 | 1.9 | 2.0 | 2.9 | 2.7 | 3.5 | 2.1 | 1.8 | 1.8 | 1.8 |
| | VOLUME RESISTIVITY | $\mu\Omega \cdot cm$ | | | 24 | 36 | 110 | 28 | 36 | OR | 27 | 48 | 35 | 48 | 19 | 78 | 177 | OR | OR |

\* OR MEANS THAT RESISTANCE IS TOO HIGH TO BE MEASURED.

EXMPL=EXAMPLE COMP. EXMPL=COMPARATIVE EXAMPLE

EP 2 637 175 B1

<Example 13>

In order to confirm that the addition does not rely on the particle diameter, particles having a larger particle diameter was used. The same procedure as in Example 1 was repeated except that a silver flaky-shaped powder coated with sorbic acid (average particle diameter: 3 $\mu$m, ratio of the coating agent: 0.1% by mass) was used instead of silver nanoparticles in Example 1 and the amount to be blended was changed as shown in Table 2. Physical properties of the resulting fired film are shown together in Table 2. The silver flaky-shaped powder was silver microparticles.

<Example 14>

The same procedure as in Example 13 was repeated except that the addition amount of malonic acid in Example 13 was decreased to the amount shown in Table 2. Physical properties of the resulting fired film are shown in Table 2. As shown in Table 2, a conductive film having a relatively high resistance can be formed.

<Comparative Example 4>

The same procedure as in Example 13 was repeated except that malonic acid was not added in Example 13. Physical properties of the resulting fired film are shown together in Table 2. It is shown that when malonic acid was not added, the film had no conductivity.

<Comparative Example 5>

The same procedure as in Example 13 was repeated except that silver flaky-shaped powder coated with oleic acid (number of carbon atoms: 18) was used instead of the silver flaky-shaped powder used in Example 13. Physical properties of the resulting fired film are shown in Table 2. It is shown that although malonic acid as an additive was added, the film using olefin acid which has a long chain had no conductivity.

Example 15

In order to confirm that the same effect is obtained in a mixture state of silver nanoparticles and silver microparticles, the same procedure as in Example 13 was repeated except that sorbic acid-coated silver nanoparticles used in Example 1 was used instead of the flaky-shaped powder in an amount half the amount in Example 13. Physical properties of the resulting fired film are shown together in Table 2. It was confirmed that the conductive film (28 $\mu\Omega\cdot$cm) having a resistance lower than that in Example 13 (39 $\mu\Omega\cdot$cm) was formed.

[Table 2]

| | | | EXMPL13 | EXMPL14 | COMP. EXMPL4 | COMP. EXMPL5 | EXMPL15 |
|---|---|---|---|---|---|---|---|
| MIXED COMPONENTS | AMOUNT OF SILVER PARTICLE (g) | SPHERICAL 100nm | — | — | — | — | 35.0 |
| | | SORBIC ACID / FLAKY-SHAPED 3µm | 70.0 | 70.0 | 70.0 | — | 35.0 |
| | | OLEIC ACID / FLAKY-SHAPED 3µm | — | — | — | 70.0 | — |
| | AMOUNT OF ADDITIVE(g) MALONIC ACID | | 0.14 | 0.02 | — | 0.14 | 0.14 |
| | AMOUNT OF SILVER PARTICLE-COATING AGENT | | 2.5 | 0.25 | 0 | 2.5 | 0.44 |
| | AMOUNT OF RESIN (g) UREARNO 8001 (POLYURETHANE RESIN) | | 22.3 | 22.3 | 22.3 | 22.3 | 22.3 |
| | AMOUNT OF SOLVENT(g) BCA (BUTYL CARBITOL ACETATE) | | 1.3 | 2.1 | 1.6 | 2.6 | 5.1 |
| | AMOUNT OF DISPERSANT(g) AJISPER PA-111 | | 0.35 | 0.35 | 0.35 | 0.35 | 0.35 |
| EVALUATION | FILM THICKNESS µm | | 3.1 | 2.8 | 2.8 | 2.7 | 2.8 |
| | VOLUME RESISTIVITY µΩ·cm | | 39 | 204 | OR | OR | 28 |

EXMPL=EXAMPLE  COMP. = COMPARATIVE EXMPL = EXAMPLE

* OR MEANS THAT RESISTANCE IS TOO HIGH TO BE MEASURED

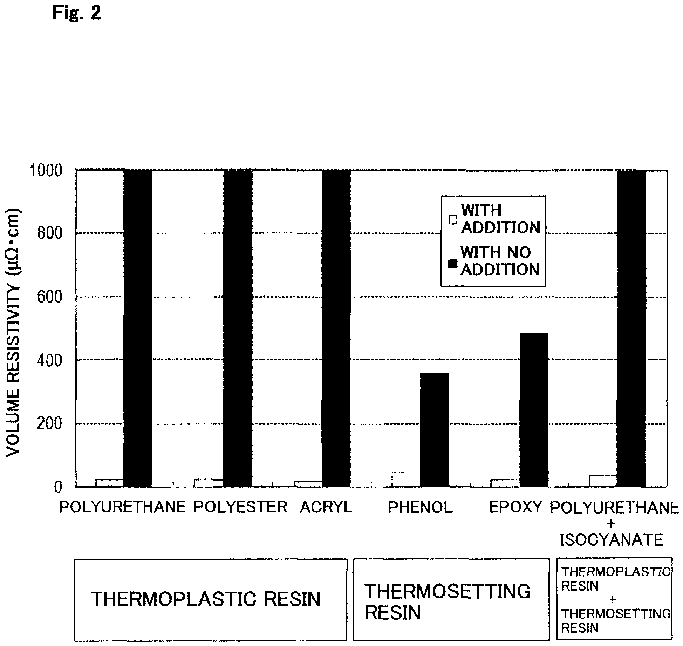

In order to show that there is no property in which the effect is expressed only in a particular resin, examples using various resins were performed. Fig. 2 shows comparison of volume resistivity values thereof. Hereinafter, this will be described in detail.

<Example 16 and Comparative Example 6>

The same procedure as in Example 1 was repeated except that the amount of the resin (thermoplastic polyurethane resin UREARNO 8001) (22.3 g) in Example 1 was changed into the amount (10.6 g) shown in Table 3. Comparative Example 6 shows a case where the same procedure as in Example 16 was performed except that malonic acid was not added. As shown in Table 3, when malonic acid was added, the volume resistivity was decreased from an unmeasurable level (Comparative Example 6) to 23 $\mu\Omega\cdot$cm (Example 16). This shows that the conductivity was dramatically improved.

<Example 17 and Comparative Example 7>

The same procedure as in Example 1 was repeated except that the resin (thermoplastic polyurethane resin UREARNO 8001) in Example 1 was changed into another resin (thermoplastic polyester resin Byron 500 available from TOYOBO CO., LTD., polyester resin solid content: 100% by mass), and the amount thereof was changed into the amount as shown in Table 3 (3.7 g). Comparative Example 7 shows results of a case where the same procedure as in Example 17 was performed except that malonic acid was not added. As shown in Table 3, when malonic acid was added, the volume resistivity was decreased from unmeasurable level (Comparative Example 7) to 26 $\mu\Omega\cdot$cm (Example 17). This shows that the conductivity was dramatically improved.

<Example 18 and Comparative Example 8>

The same procedure as in Example 1 was repeated except that the resin (thermoplastic polyurethane resin UREARNO 8001) in Example 1 was changed into another resin (thermoplastic acrylic resin BR-102 available from MITSUBISHI RAYON CO., LTD., acrylic resin solid content: 100% by mass), the solvent (butyl carbitol acetate) was changed into another solvent (terpineol available from Wako Pure Chemical Industries, Ltd.), and the amount was changed into the amount shown in Table 3 (3.7 g). Comparative Example 8 shows results of a case where the same procedure as in Example 18 was performed except that malonic acid was not added. As shown in Table 3, when malonic acid was added, the volume resistivity was decreased from 6300 $\mu\Omega\cdot$cm (Comparative Example 8) to 18 $\mu\Omega\cdot$cm (Example 18). This shows that the conductivity was dramatically improved.

<Example 19 and Comparative Example 9>

The same procedure as in Example 1 was repeated except that the resin (thermoplastic polyurethane resin UREARNO 8001) was changed into another resin (thermosetting phenolic resin PL4348) in Example 1, and the amount was changed into the amount shown in Table 3 (6.7 g). Comparative Example 9 shows results of a case where the same procedure as in Example 19 was performed except that malonic acid was not added. As shown in Table 3, when malonic acid was added, the volume resistivity as decreased from 360 $\mu\Omega\cdot$cm (Comparative Example 9) to 49 $\mu\Omega\cdot$cm (Example 19). This shows that the conductivity was dramatically improved.

<Example 20 and Comparative Example 10>

The same procedure as in Example 1 was repeated except that the resin (thermoplastic polyurethane resin UREARNO 8001) in Example 1 was changed into a thermosetting epoxy resin (8282XA available from Mitsubishi Chemical Corporation, epoxy resin solid content: 100% by mass), the solvent (butyl carbitol acetate) was changed into another solvent (terpineol), and the amount was changed into the amount shown in Table 3 (3.7 g). Comparative Example 10 shows results of a case where the same procedure as in Example 20 was performed except that malonic acid was not added. As shown in Table 3, when malonic acid was added, the volume resistivity was decreased from 484 $\mu\Omega\cdot$cm (Comparative Example 10) to 23 $\mu\Omega\cdot$cm (Example 20). This shows that the conductivity was dramatically improved.

<Example 21 and Comparative Example 11>

The same procedure as in Example 1 was repeated except that 22.3 g of the resin in Example 1 (thermoplastic polyurethane resin UREARNO 8001) was changed into 2.8 g of thermosetting isocyanate resin (DURANATE SBN-70D available from Asahi Kasei Chemicals Corporation) and the amount of the thermoplastic polyurethane resin UREARNO 8001 was changed into 16.5 g.

Comparative Example 11 shows results of a case where the same procedure as in Example 21 was performed except that malonic acid was not added. As shown in Table 3, when malonic acid was added, the volume resistivity was decreased from unmeasurable level (Comparative Example 11) to 38 $\mu\Omega\cdot$cm (Example 21). This shows that the conductivity was dramatically improved. The color difference of the films was measured by a color difference meter. In Example 21, L* was 52.98, a* was -0.52, and b* was 9.37. In Comparative Example 11, L* was 64.96, a* was 3.90, and b* was 7.78.

<Example 22>

The same procedure as in Example 1 was repeated except that the kind of the silver nanoparticle forming a conductive paste, the addition amount thereof, and the addition amount of the solvent, dispersant, and resin in Example 1 were changed as shown in Table 3. The solvent was changed into phenyl glycol (available from Nippon Nyukazai Co., Ltd.). Physical properties of the resulting fired film are shown in Table 3.

<Example 23>

The same procedure as in Example 21 was repeated except that the kind of the silver nanoparticle forming a conductive paste, and the addition amounts of malonic acid and dispersant in Example 21 were changed as shown in Table 3. Physical properties of the resulting fired film are shown together in Table 3.

Fig. 2 shows a relation between the resin and the volume resistivity in Examples 16 to 21 and Comparative Examples 6 to 11. The horizontal axis represents the kinds of resin, and the vertical axis represents volume resistivity ($\mu\Omega\cdot$cm). The black bar represents a case where malonic acid was not added, and the white bar represents a case where malonic acid was added. The kinds in the horizontal axis are selected from typical thermoplastic resins and thermosetting resins. A case where the resistance was too high and measurement could not be performed is represented by "OR" in Table 3, and by 1000 $\mu\Omega\cdot$cm in the black bar of Fig. 2.

As seen from Fig. 2, in a case of the thermoplastic resin, when malonic acid was not added, the volume resistance value exceeded measurement limit. When malonic acid was added, the volume resistance value was decreased to a few tens $\mu\Omega\cdot$cm. In a case of the thermosetting resin, when malonic acid was not added, the volume resistivity was a few hundreds $\mu\Omega\cdot$cm. On the other hand, when malonic acid was added, the volume resistivity was decreased to a few tens $\mu\Omega\cdot$cm.

[Table 3]

| MIXED COMPONENTS | | | EXMPL 16 | COMP. EXMPL 6 | EXMPL 17 | COMP. EXMPL 7 | EXMPL 18 | COMP. EXMPL 8 | EXMPL 19 | COMP. EXMPL 9 | EXMPL 20 | COMP. EXMPL 10 | EXMPL 21 | COMP. EXMPL 11 | EXMPL 22 | EXMPL 23 |
|---|---|---|---|---|---|---|---|---|---|---|---|---|---|---|---|---|
| AMOUNT OF SILVER PARTICLE (g) | SORBIC ACID | SPHERICAL 100nm | 70.0 | 70.0 | 70.0 | 70.0 | 70.0 | 70.0 | 70.0 | 70.0 | 70.0 | 70.0 | 70.0 | 70.0 | — | — |
| | | SPHERICAL 60nm | — | — | — | — | — | — | — | — | — | — | — | — | 56.0 | 70.0 |
| AMOUNT OF ADDITIVE(g) | MALONIC ACID | | 0.14 | — | 0.14 | — | 0.14 | — | 0.14 | — | 0.14 | — | 0.14 | — | 0.14 | 0.21 |
| AMOUNT OF SILVER PARTICLE-COATING AGENT | | | 0.25 | 0 | 0.25 | 0 | 0.25 | 0 | 0.25 | 0 | 0.25 | 0 | 0.25 | 0 | 0.25 | 0.25 |
| AMOUNT OF RESIN(g) | THERMO-PLASTIC | UREARNO 8001 (POLYURETHANE RESIN) | 10.6 | 10.6 | — | — | — | — | — | — | — | — | 16.5 | 16.5 | 21.4 | 16.5 |
| | | BYRON 500 (POLYESTER RESIN) | — | — | 3.7 | 3.7 | — | — | — | — | — | — | — | — | — | — |
| | | BR-102 (ACRYLIC RESIN) | — | — | — | — | 3.7 | 3.7 | — | — | — | — | — | — | — | — |
| | THERMO-SETTING | PL4348 (PHENOL RESIN) | — | — | — | — | — | — | 6.7 | 6.7 | — | — | — | — | — | — |
| | | 828XA (EPOXY RESIN) | — | — | — | — | — | — | — | — | 3.7 | 3.7 | — | — | — | — |
| | | SBN-70D (ISOCYANATE RESIN) | — | — | — | — | — | — | — | — | — | — | 2.8 | 2.8 | — | 2.8 |
| AMOUNT OF SOLVENT(g) | BCA (BUTYL CARBITOL ACETATE) | | 10.5 | 10.5 | 12.8 | 12.8 | 16.3 | 18.3 | 5.7 | 12.5 | — | — | 16.7 | 15.4 | — | 20.1 |
| | TPO (TERPINEOL) | | — | — | — | — | — | — | — | — | 7.3 | 7.3 | — | — | — | — |
| | PhG (PHENYL GLYCOL) | | — | — | — | — | — | — | — | — | — | — | — | — | 22.7 | — |
| AMOUNT OF DISPERSANT(g) | AJISPER PA-111 | | 0.35 | 0.35 | 0.35 | 0.35 | 0.35 | 0.35 | 0.35 | 0.35 | 0.35 | 0.35 | 0.35 | 0.35 | 0.28 | 0.70 |
| EVALUATION | FILM THICKNESS | μm | 15.2 | 7.9 | 16.0 | 8.3 | 9.5 | 7.9 | 17.1 | 11.4 | 28.0 | 14.0 | 12.0 | 10.1 | 8.6 | 11.4 |
| | VOLUME RESISTIVITY | μΩ·cm | 23 | OR | 26 | OR | 18 | 6300 | 49 | 360 | 23 | 484 | 38 | OR | 58 | 58 |

EXMPLE=EXAMPLE  COMP.=COMPARATIVE EXAMPLE EXMPL

\* OR MEANS THAT RESISTANCE IS TOO HIGH TO BE MEASURED

Table 4 shows a relation between the results of measurement of color specification and volume resistivities in Examples 1, 2, 7, 18, 19, and 21 and Comparative Examples 1, 2, 8, 9, and 11 among all Examples and Comparative Examples. In Examples in which the volume resistivity was a few tens $\mu\Omega\cdot$cm, all a* were 2.0 or less. The volume resistivity of Comparative Examples in which a* was more than 2.0 was very high.

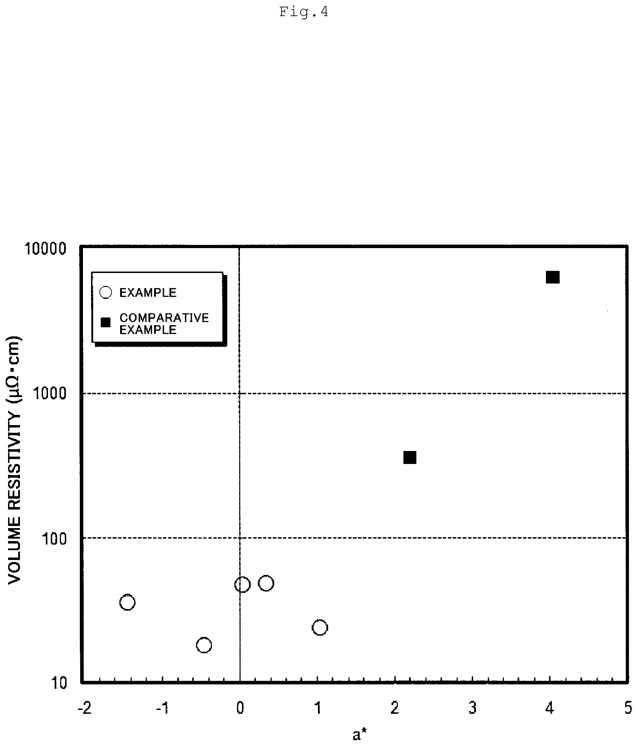

Fig. 4 shows a relation between a* and the volume resistivity ($\mu\Omega\cdot$cm). The vertical axis represents volume resistivity ($\mu\Omega\cdot$cm), and the horizontal axis represents a*. It is shown that when a* was 2.0 or less, the volume resistivity was decreased. Since plots in Fig. 4 includes Examples using a different resin, Fig. 4 shows that the volume resistivity can be decreased regardless of the kind of resin when a dicarboxylic acid is contained as shown in the present invention.

[Table 4]

| | EXMP1 | EXMP2 | EXMP7 | EXMP18 | EXMP19 | EXMP21 | COMP. EXMPL1 | COMP. EXMPL2 | COMP. EXMPL8 | COMP. EXMPL9 | COMP. EXMP11 |
|---|---|---|---|---|---|---|---|---|---|---|---|
| L* | 60.89 | 60.05 | 62.66 | 66.01 | 60.15 | 52.98 | 63.54 | 55.39 | 62.51 | 60.65 | 64.96 |
| a* | 1.04 | -1.45 | 0.04 | -0.46 | 0.34 | -0.52 | 4.04 | 2.20 | 6.91 | 4.68 | 3.90 |
| b* | 9.31 | 15.51 | 15.05 | 15.50 | 10.24 | 9.37 | 4.05 | 4.44 | 6.74 | 11.82 | 7.78 |
| VOLUME RESISTIVITY ($\mu\Omega\cdot$cm) | 24 | 36 | 48 | 18 | 49 | 38 | OR | OR | 6300 | 360 | OR |

* OR MEANS THAT RESISTANCE IS TOO HIGH TO BE MEASURED.
EXMPL=EXAMPLE
COMP. EXMPL=COMPARATIVE EXAMPLE

Industrial Applicability

The conductive paste according to the present invention can be suitably used for "printed electronics." Further, the conductive paste can be used for printed CPU, printed illumination, printed tags, all print display, sensors, printed wiring boards, organic solar cells, Electronic Book, nanoimprint LED, liquid crystalline/PDP panels, and print memory, which are being investigated.

**Claims**

1. A conductive paste comprising: silver particles coated with an organic substance composed of a carboxylic acid having 2 to 6 carbon atoms or a derivative thereof, a dispersion medium, a resin, and a dicarboxylic acid having 2 to 8 carbon atoms.

2. The conductive paste according to claim 1, wherein an amount of the dicarboxylic acid to be added to the conductive paste is 0.01 to 2.0% by mass with respect to a total mass of the conductive paste.

3. The conductive paste according to any one of claims 1 to 2, further comprising a dispersant.

4. The conductive paste according to any one of claims 1 to 3, wherein any one or both of a thermosetting resin and a thermoplastic resin is used.

5. The conductive paste according to any one of claims 1 to 4, wherein a wiring formed by subjecting the conductive paste to a heat treatment has a property expressing conductivity by bringing silver particles into contact with one another or sintering them.

6. A conductive film obtained from the conductive paste according to any of claims 1 to 5, wherein the conductive film has an a* value of 2.0 or less when the L*a*b* color space is used.

7. A method for forming a conductive film, comprising: applying the conductive paste according to any of claims 1 to 5 to a substrate, and subjecting the conductive paste to a heat treatment at 100 to 200°C in the air or an inert atmosphere.

**Patentansprüche**

1. Leitfähige Paste, Folgendes umfassend: Silberpartikel, beschichtet mit einer organischen Substanz, bestehend aus einer Carbonsäure mit 2 bis 6 Kohlenstoffatomen oder einem Derivat davon, ein Dispersionsmittel, ein Harz und eine Dicarbonsäure mit 2 bis 8 Kohlenstoffatomen.

2. Leitfähige Paste nach Anspruch 1, wobei eine Menge der Dicarbonsäure, die zu der leitfähigen Paste hinzugefügt werden soll, 0,01 bis 2,0 Gew.-% hinsichtlich einer gesamten Masse der leitfähigen Paste ist.

3. Leitfähige Paste nach einem der Ansprüche 1 bis 2, ferner einen Dispergator umfassend.

4. Leitfähige Paste nach einem der Ansprüche 1 bis 3, wobei ein duroplastisches Harz und/oder ein thermoplastisches Harz verwendet wird.

5. Leitfähige Paste nach einem der Ansprüche 1 bis 4, wobei eine Verkabelung, ausgebildet durch das Unterziehen der leitfähigen Paste einer Wärmebehandlung, eine Eigenschaft aufweist, die Leitfähigkeit durch das Inverbindungbringen von Silberpartikeln miteinander oder durch deren Sintern ausdrückt.

6. Leitfähiger Film, der von der leitfähigen Paste nach einem der Ansprüche 1 bis 5 gewonnen wird, wobei der leitfähige Film einen a*-Wert von 2,0 oder weniger aufweist, wenn der L*a*b*-Farbenraum verwendet wird.

7. Verfahren zum Ausbilden eines leitfähigen Films, Folgendes umfassend:

Auftragen der leitfähigen Paste nach einem der Ansprüche 1 bis 5 auf ein Substrat, und

Unterziehen der leitfähigen Paste einer Wärmebehandlung bei 100 °C bis 200 °C an der Luft oder in einer Schutzgasatmosphäre.

**Revendications**

1. Pâte conductrice comprenant : des particules d'argent recouvertes d'une substance organique composée d'un acide carboxylique ayant de 2 à 6 atomes de carbone ou d'un dérivé de celui-ci, d'un milieu de dispersion, d'une résine et d'un acide dicarboxylique ayant de 2 à 8 atomes de carbone.

2. Pâte conductrice selon la revendication 1, dans laquelle une quantité de l'acide dicarboxylique à ajouter à la pâte conductrice est comprise entre 0,01 et 2,0 % en masse par rapport à une masse totale de la pâte conductrice.

3. Pâte conductrice selon l'une quelconque des revendications 1 à 2, comprenant en outre un dispersant.

4. Pâte conductrice selon l'une quelconque des revendications 1 à 3, dans laquelle une quelconque résine, ou les deux résines, parmi une résine thermodurcissable et une résine thermoplastique est/sont utilisée(s).

5. Pâte conductrice selon l'une quelconque des revendications 1 à 4, dans laquelle un câblage formé en soumettant la pâte conductrice à un traitement thermique a une propriété exprimant une conductivité en mettant des particules d'argent en contact les unes avec les autres ou en les frittant.

6. Film conducteur obtenu à partir de la pâte conductrice selon l'une quelconque des revendications 1 à 5, dans lequel le film conducteur a une valeur a* inférieure ou égale à 2,0 lorsque l'espace de couleur L*a*b* est utilisé.

7. Procédé pour former un film conducteur, comprenant les étapes suivantes : appliquer la pâte conductrice selon l'une quelconque des revendications 1 à 5 à un substrat et soumettre la pâte conductrice à un traitement thermique entre 100 et 200 °C dans l'air ou dans une atmosphère inerte.

**Fig. 1**

Fig. 2

Fig.3

Fig.4

**EP 2 637 175 B1**

**Patent documents cited in the description**

- JP 2010132736 A
- JP 2009298963 A
- JP 2008166086 A
- JP 2010153184 A